(19) Europäisches Patentamt
European Patent Office
Office européen des brevets

(11) Publication number: **0 187 150 B1**

(12) # EUROPEAN PATENT SPECIFICATION

(45) Date of publication of patent specification: **06.11.91**

(51) Int. Cl.5: **H05K 3/42**, H05K 3/46, C23C 18/18

(21) Application number: **85902778.1**

(22) Date of filing: **08.05.85**

(86) International application number: **PCT/US85/00857**

(87) International publication number: **WO 85/05755 (19.12.85 85/27)**

(54) **COMPOSITION AND PROCESS FOR CONDITIONING THE SURFACE OF PLASTIC SUBSTRATES PRIOR TO METAL PLATING.**

(30) Priority: **29.05.84 US 614912**

(43) Date of publication of application: **16.07.86 Bulletin 86/29**

(45) Publication of the grant of the patent: **06.11.91 Bulletin 91/45**

(84) Designated Contracting States: **AT BE CH DE FR IT LI LU NL SE**

(56) References cited:
**US-A- 3 898 136**
**US-A- 4 086 128**
**US-A- 4 515 829**

**CIRCUITS MANUFACTURING, ISSUED MARCH 1983 PETER E. KUKANSIS, "IMPROVED SMEAR REMOVAL", PPS 73, 74**

(73) Proprietor: **ENTHONE, INCORPORATED**
**350 Frontage Road**
**West Haven, CT 06516(US)**

(72) Inventor: **DEL GOBBO, Anthony, R.**
**1034 Guernseytown Road**
**Watertown, CT 06795(US)**

(74) Representative: **Massari, Marcello**
**Studio M. Massari S.r.l. 23, Via Fontanella Borghese**
**I-00186 Roma(IT)**

**EP 0 187 150 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Technical Field

The invention relates to the metal plating of plastics and, in particular, to enhancing the adhesion of metal plating to the plastic substrate of electronic circuit boards by conditioning the board prior to etching and electroless metal plating of the board by making use of an alkaline composition comprising a first compound (a) and a second compound (b).

The metal plating of plastic parts is well-known to be of considerable commercial importance because the desirable characteristics of both the plastic and the metal are combined to offer the technical and aesthetic advantages of each. Thus, a part plated with a bright, metallic finish takes advantage of the economies in cost and weight afforded by substituting molded plastic parts for metal and, additionally, the plated finishes are not as susceptible to pitting and corrosion because there is no galvanic reaction between a plastic substrate and a plated metal.

An important process is the preparation of electronic circuit boards which requires the electroless plating of a conductive metal layer, usually copper, onto the plastic substrate of the board, such as epoxy, and for convenience the following description will relate specifically to this process.

These boards vary in design and may have a copper layer on each surface face of the epoxy (two-sided boards) or they can be multi-layer boards which have a plurality of inter-leaved parallel planar copper and epoxy layers. In both type boards through-holes are drilled in the board and metal plated to facilitate connection between the circuits on the copper layers. The through-holes present an additional plating problem because resin smear on the exposed copper caused by the drilling operation acts as an insulator between the metal of the through-hole and copper layer and must be removed prior to plating. The smear is usually removed using acid and this process degrades the physical integrity of the hole making it difficult to metallize and provides little or no adhesive support for the metallic deposit.

The problems in plating either the through-holes or other plastic parts of the board are well-known in the art and a number of methods have been developed to improve the adhesion of the metal plating to the epoxy. These methods generally employ oxidants to etch the surface of the plastic prior to plating and include chromic acid, sulfuric acid and acidic and alkaline permanganate solutions. The toxicity of the chromium compounds and their potential hazards as water pollutants and the safety precautions needed with sulfuric acid have increased the commercial use of permanganate solutions, particularly alkaline permanganate solutions, and a number of patents have been granted in this area.

Background Art

U.S. Patent No. 3,652,351 shows the etching of acrylonitrile-butadiene-styrene interpolymers (ABS plastics) using a composition containing manganate and hydroxyl ions. U.S. Patent Nos. 4,042,729 and 4,054,693 disclose stable, highly active etching solutions containing controlled ratios of manganate ions and permanganate ions and a pH in the range of 11 to 13. U.S. Patent No. 4,425,380 is specifically directed to cleaning through-holes of residual manganese prior to plating by contacting the etched plastic with a water soluble compound oxidizable by permanganate to reduce the manganese residues to a low oxidation state, e.g., $SnCl_2$-HCl, formaldehyde, followed by contacting with hot alkaline hydroxide. The disclosures of the above patents are hereby incorporated by reference.

Also, US-A-3,898,136 regards the metal plating of plastics and it describes and claims a process for treating the surface of an article with a compound having the formula $RO(AO)_nR'$ prior to etching the surface thereof and thereafter metal plating the article. Therein, various compounds for use in the treatment are exemplified and it is also stated that the compounds may be used either alone or in combination. However, there is no specific disclosure of the use of the combination of compounds of the present invention.

Furthermore, US-A-3,898,136 does not teach towards such a combination and in this respect, it is noted that, of the many compounds mentioned, only propylene glycol monomethyl ether and propylene glycol dimethyl ether fall within the general formula for compound (a) while diethylene glycol methyl ether is the only specified example of a compound of type (b). The possible combinations of the many compositions listed therein are of enormous magnitude, and there is nothing in the document which would lead the skilled reader to choose a combination of compound of type (a) and type (b) as set forth in the invention. Furthermore, there is no suggestion that the compounds employed for the treating should be used in the form of an alkaline composition.

Publication Circuit Manufacturing issued March 1983, Peter E. Kukanskis "Improved Smear Removal" is generally dealing with the treatment of circuit boards but it does not suggest the particular combination of

compounds (a) and (b) of the application in a solution having a pH greater than 10. Moreover, alkaline aqueous solvent blends are not specifically mentioned and certainly the particular combination of compounds (a) and (b) in an alkaline solution of the invention is not suggested thereby.

The present invention relates to treating the plastic surface before plating an particularly before etching to further enhance the adhesive effect of the etching procedure. This procedure is generally known as a solvent-etch technique and employs solvents which swell the plastic. U.S. Patent No. 3,758,332 discloses the use of chemicals such as methyl ethyl ketone, tetrahydrofuran, dioxane, pyridine, dimethylformamide, and an alcohol mixture comprising methyl ethyl ketone, ethanol and methanol as swellants for epoxy resin. U.S. Patent No. 4,086,128 also shows pretreatment of an epoxy resin with an organic solvent comprising alcohols, acids, esters, ketones, nitriles, nitro compounds, and polyhydric compounds such as ethylene glycol, glycerine and 1, 2-propylene glycol prior to etching with hydrogen peroxide and sulfuric acid. U.S. Patent No. 3,865,623 shows immersion of epoxy resin in an organic solvent such as dimethylformamide to render the epoxy receptive to an acid etch. The disclosures of the above publications are hereby incorporated by reference.

## Disclosure of Invention

It has now been discovered that the adhesiveness of metal plating and, in particular, electroless metal plating, to plastic substrates can be enhanced by first contacting the plastic substrate for an effective time with an alkaline composition comprising:

(a) a compound represented by the general formula,

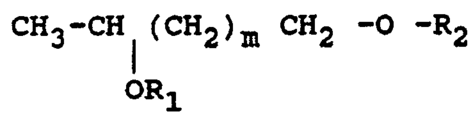

and

(b) a compound represented by the general formula,

$R_3\ (OCH_2CH_2)_n\ O - R_4$

wherein, $R_1$ and $R_2$ are independently selected from the group consisting of hydrogen atoms, aryl groups and alkyl groups of 1-4 carbon atoms, m is 0 to 2; and wherein $R_3$ and $R_4$ are independently selected from the group consisting of aryl groups and alkyl groups of 1-4 carbon atoms and n is 2 to 5; the compositions comprising, by weight about 10 grams/liter (g/l) to saturation compound (a) and about 10 g/l to saturation compound (b) and the composition having a pH greater than 10.

The pH of the composition is highly alkaline, preferably greater than 13, e.g., 14. It is preferred to employ a source of hydroxyl ions such as an alkali metal hydroxide and may be present in an amount of about 5 g/l to 200 g/l or more. Compound (a) is preferably propylene glycol monomethyl ether and compound (b) dimethoxy tetra ethylene glycol, with compounds (a) and (b) each being present in the solution in an amount of about 40 g/l to 120 g/l.

The composition is employed at an elevated temperature and is, in general, about 90° F (32° C) to the lesser of the boiling point of the solution and the softening point of the plastic. For epoxy boards the temperature is preferably about 140 to 150° F (60 to 66° C). (Temperatures given in degrees Celsius are approximate, i.e., the nearest whole degree Celsius to the corresponding temperature in degrees Fahrenheit, and are provided solely as a convenience to the reader.)

The effective contact time will vary with the concentration and temperature of the solution and the plastic substrate being treated and in general will not exceed about 30 minutes, preferably less than 10 minutes, e.g., 5 minutes. For epoxy boards which are to be etched with alkaline permanganate solutions a contact time of about 2 to 10 minutes at a temperature of about 140-150° F (60 - 66° C) has been found to provide excellent results.

The invention further provides a method for treating a plastic substrate and an epoxy circuit board according to claims 6 and 15.

In general, the process of using the compositions of the invention in manufacturing printed circuit boards and, in particular, boards containing through-holes is a sequence of steps commencing with a commercially available laminate or multi-laminate made from, e.g., paper-epoxy or glass-epoxy material. A pre-designed series of through-holes is formed in the board in any conventional manner, then preferably

etched with an acid to remove any epoxy smear over the exposed metal laminate surface and to etch-back the epoxy layer, and water rinsed. This is followed by contacting the board with the composition of the invention to enhance the effect of the subsequent oxidative etching step. After water rinsing, the board is etched with an oxidant such as alkaline permanganate and water rinsed. Neutralization with a reductant to solubilize manganese residues by lowering their oxidation state is then performed and the board rinsed providing a board having all the copper layers in the through-holes exposed and the epoxy etched ready for electroless metal plating using conventional procedures. A preferred step is to now dissolve some of the glass fibers in the epoxy using, for example, acid flourides, and to pretreat the board by cleaning with a composition such as ENPLATE® PC-475 to remove hydrocarbon soils and oxide and micro-etching of the copper using an etchant such as ENPLATE AD-485. Thereafter the board is immersed in a catalyst, such as a tin-palladium solution, which conditions the surfaces of the epoxy for electroless copper plating. ENPLATE Activator 444 sold by Enthone, Incorporated is exemplary of this type catalyst. Following a water rinse, the laminate is immersed in an accelerator such as ENPLATE PA-491 to activate the catalyst by freeing the metal palladium ions on the board. After a water rinse, the board is dried and is immersed in an electroless copper plating solution for a period of time sufficient to plate copper to the desired thickness on the surfaces and to plate the surfaces of the holes to form through-hole connections between the laminate surfaces. ENPLATE CU-700 and other similar plating compositions may be employed. The boards may then be electroplated using conventional techniques if a thicker coating is desired.

## Best Mode for Carrying Out the Invention

The compositions of the invention have been found to be particularly useful for conditioning epoxy resins although other suitable polymeric resins may also be conditioned. The electronic circuit boards are commercially available and are of known structure and composition and include paper-epoxy and glass-epoxy laminates. In general, an epoxy resin means a polymeric compound containing at least two epoxy groups in one molecule and synthetic resins formed by ring-opening reactions of the epoxy groups of the compounds. An epoxy resin extensively used in the printed circuit industry is a cured epoxy resulting from a condensation product of epichlorohydrin and bisphenol A. A board commercially known and available under designation FR-4 which is a fire retardant epoxy resin fiber glass cloth laminate, has demonstrated to be effectively conditioned by the process of the invention.

The epoxy resin may contain glass fibers, paper, synthetic fibers, carbon black, alumina powders, silica powders, wax, etc., as fillers, pigments, mold release agents, reinforcing agents, etc., or can be used together with phenol resins, urea resins, melamine resins, and the like.

The alkaline pH of the composition may be provided by any suitable source and is preferably an alkaline hydroxide such as lithium, sodium, potassium, cesium, and tetraalkyl ammonium. Sodium hydroxide is preferred. The amount of hydroxyl ions can vary widely and is more preferably about 40 to 120 g/l and most preferably about 60 to 100 g/l.

The compound represented by the formula:

$$CH_3-\underset{\displaystyle OR_1}{\underset{|}{CH}}(CH_2)_m\ CH_2-O-R_2$$

is preferably propylene glycol monomethyl ether. Other compounds include propylent glycol monoethyl ether and propylene glycol monopropyl ether. A mixture of compounds wherein $R_1$ is hydrogen and m is 1 and $R_2$ is methyl, ethyl and propyl has provided satisfactory results. The compound is preferably present in the solution in an amount about 40 to 120 g/l, most preferably about 60 to 100 g/l.

The compound represented by the formula

$$R_3-(OCH_2CH_2)_n-O-R_4$$

is preferably dimethoxy tetra ethylene glycol, wherein $R_3$ and $R_4$ are methyl and n is 4. Dimethoxy tri ethylene glycol (n is 3) provides satisfactory results although the tetra ethylene glycol compound is preferred. The compound is present in the solution in an amount about 40 to 120 g/l, most preferably about 60 to 100 g/l.

It will be apprecited by those familiar with the art that the components of the composition may vary widely, depending upon, for example, solubility considerations, with the understanding that the important

criteria is the combination of compounds (a) and (b) in an alkaline solution.

Other additives, such as surfactants, may be used in the composition for special purposes as is known in the art.

The composition media is preferably aqueous and substantially inert with respect to the plastic being treated. Other media may also be employed such as alcohols with water being preferred for economic reasons and for its demonstrated effectiveness.

To practice the method of the invention the plastic substrate is contacted with the composition at an elevated temperature for a time sufficient to render the surface receptive to the permanganate etching process. Contacting procedures may vary widely and satisfactory results for epoxy resin are provided by immersing the part in the solvent for between approximately 2 to l0 minutes at l40 to l50 °F (60 to 66 °C). The time and temperature will vary depending on the substrate being treated and the composition of the solution as will be appreciated by those skilled in the art. Other means such as spraying, may be used for treating the plastic part.

The treated plastic part is then ready for oxidative etching, preferably with a hot alkaline permanganate solution as described in U.S. Patent Nos. 4,042,729; 4,054,693 and 4,425,380, and basically comprises contacting the treated plastic part with the permanganate solution at an elevated temperature for a sufficient time to promote adhesion to the surface. It is preferred to then rinse the etched plastic part to remove excess solution and to remove the manganese residues by neutralization or chemical reduction using reductants such as hydrazine and oxalic acid.

The etched plastic part is now prepared for metal plating by known means such as sensitizing using an aqueous tin chloride solution and then activating by means of palladium chloride. The surface may now be plated with a film of metal by electroless plating. Sensitizing, activating and plating compositions and methods for copper metal electroless deposition are described in U.S. Patent Nos. 2,874,072; 3,075,855; 3,095,309; and 3,736,l56; the disclosures of said patents being hereby incorporated reference. Other methods of deposition may also be used such as vacuum vapor deposition, electrolytic plating or a combination of electroless plating and electrolytic plating.

The present invention will now be described in detail by reference to the following examples.

EXAMPLE I

The following example illustrates the use of the composition to enhance the adhesiveness of electroless plated copper to epoxy resin which was cleaned with sulfuric acid.

A two-sided copper clad epoxy-glass FR-4 laminate board was metallized using the following procedure:

(a) strip the copper clad from the surface of the board with 50% $HNO_3$ at room temperature;
(b) rinse in water;
(c) clean the surface with 96% sulfuric acid for 45 seconds at room temperature;
(d) rinse in water for 5 minutes to remove acid residues;
(e) immerse the board for 5 minutes at l45 °F (63 °C) with mild agitation in a solution comprising:

| | |
|---|---|
| NaOH | 90g |
| Dimethoxy Tetraethylene Glycol | 80g |
| Propylene Glycol Monomethyl Ether | 80g |
| Water (to make) | l000ml |

(f) rinse for 5 minutes in water;
(g) etch for l0 minutes at l50 °F (66 °C) with mild agitation in a solution comprising:

| | |
|---|---|
| $KMnO_4$ | 65g |
| NaOH | 50g |
| Water (to make) | l000ml |

(h) rinse for 5 minutes in water;
(i) neutralize for 5 minutes at l40 °F (60 °C) in a solution comprising:

| | |
|---|---|
| Hydrazine . $H_2SO_4$ | 25g |
| HCl (37% aqueous) | 30ml |
| Water (to make) | 1000ml |

(j) rinse in water for 3 minutes;
(k) immerse in conditioning cleaner ENPLATE® PC-475 for 5 minutes at 145° F (63° C);
(l) rinse in water for 3 minutes;
(m) immerse in one-step palladium catalyst ENPLATE Activator 444 for 5 minutes at 75° F (24° C);
(n) rinse with water;
(o) immerse in post activator solution ENPLATE PA-491 for 5 minutes at room temperature;
(p) rinse in water for 2 minutes;
(q) metallize in electroless copper solution ENPLATE CU-700 for 30 minutes at 118° F (48° C); and
(r) rinse with water and air dry.

The metallized layer is tested for adhesion by firmly attaching a strip of adhesive tape to the metallized surface and then removing the tape with a quick snapping motion. There was no noticeable transfer of the metallized deposit to the adhesive backing of the tape.

COMPARATIVE EXAMPLE I

The procedure of EXAMPLE I was comparatively repeated except that step (e) (the conditioning step of the invention) was omitted. The metallized deposit was blistered and was poorly adherent with a significant transfer of the deposit to the adhesive backing of the tape.

COMPARATIVE EXAMPLE II

The procedure of EXAMPLE I was comparatively repeated except that the dimethoxy tetraethylene glycol component was omitted from the composition used in step (e). The metallized deposit was poorly adherent with a significant transfer of the deposit being removed by the tape.

EXAMPLE II

The procedure of EXAMPLE I was repeated on a drilled multi-layer epoxy-glass FR-4 laminate board. A standard copper micro-etch step using ENPLATE AD-485 was added between steps (l) and (m) and steps (a) and (b) were omitted. After metallization the board was electroplated in a standard acid copper plating solution to a deposit thickness of about 1 mil. The board was then rinsed with water, dried and coated with an activated rosin flux. The prepared board was then floated on molten tin-lead (60-40) solder at 550° F (288° C) for 10 seconds. After cooling the solder filled holes were cross-sectioned using standard metallurgical techniques. Microscopic examination of the copper to epoxy interface revealed no separation and the presence of a fine dendritic structure.

EXAMPLE III

The procedure of EXAMPLE II was repeated with the omission of the concentrated sulfuric acid step (c). Microscopic examination of the copper plating to inner layer copper foil revealed a mechanically sound connection free of smeared resin.

EXAMPLE IV

The procedure of EXAMPLE II was repeated substituting a 900 g/l solution of chromic acid at 150° F (66° C) for 2 minutes for the concentrated sulfuric acid step (c). Tightly adherent plating to the epoxy hole wall surface was obtained.

EXAMPLE V

The procedure of EXAMPLE III was repeated substituting a sample of a drilled multilayer laminate that had been exposed to a plasma desmearing process. Tightly adherent plating to the epoxy hole wall surface was obtained.

## Claims

1. An alkaline composition for improving the adhesion of plastic substrates to metal plating comprising:
(a) a compound represented by the general formula,

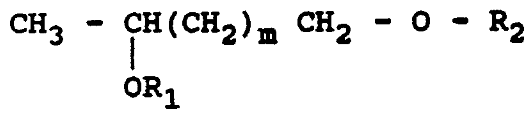

wherein $R_1$ and $R_2$ are independently selected from the group consisting of hydrogen atoms, aryl groups and alkyl groups of 1-4 carbon atoms and m is 0 to 2; and
(b) a compound represented by the general formula,

$R_3\ (OCH_2CH_2)_n\ O - R_4$

wherein $R_3$ and $R_4$ are independently selected from the group consisting of aryl groups and alkyl groups of 1-4 carbon atoms and n is 2 to 5;
the composition comprising, by weight, about 10 g/l to saturation compound (a) and about 10 g/l to saturation compound (b), and the composition having a pH greater than 10.

2. The composition of claim 1 wherein the alkalinity is provided by an alkali metal hydroxide and is about 5 g/l to 120 g/l.

3. The composition of claim 2 wherein compound (a) comprises propylene glycol monomethyl ether and compound (b) comprises dimethoxy tetra ethylene glycol.

4. The composition of claim 3 containing about 40 g/l to 120 g/l alkali metal hydroxide, about 40 g/l to 120 g/l compound (a) and about 40 g/l compound (b).

5. The composition of claim 4 wherein the alkali metal hydroxide is sodium hydroxide.

6. A method for treating a plastic substrate prior to plating comprising contacting the plastic at a temperature above 32° C with a composition, characterized in that the composition comprises:
(a) a compound represented by the general formula,

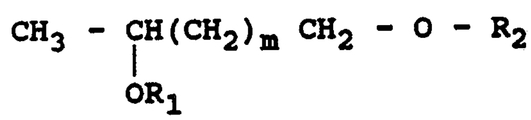

wherein $R_1$ and $R_2$ are independently selected from the group consisting of hydrogen atoms, aryl groups and alkyl groups of 1-4 carbon atoms and m is 0 to 2; and
(b) a compound represented by the general formula,

$R_3\ (OCH_2CH_2)_n\ O - R_4$

wherein $R_3$ and $R_4$ are independently selected from the group consisting of aryl groups and alkyl groups of 1-4 carbon atoms and n is 2 to 5; the composition comprising, by weight, about 10 g/l to saturation compound (a) and about 10 g/l to saturation compound (b), and the composition having a pH greater than 10.

7. The method of claim 6 wherein compound (a) comprises propylene glycol monomethyl ether and compound (b) comprises dimethoxy tetra ethylene glycol.

8. The method of claim 6 wherein the temperature is about 32° C to the lesser of the boiling point of the solution and the softening point of the plastic and the time is less than about 30 minutes.

9. The method of claim 6 wherein the temperature is about 60° to 66° C and the contact time is less than

about 10 minutes.

**10.** The method of claim 9 wherein the plastic substrate is part of an electronic circuit board which has a metal conductor upon the top and bottom sides of the substrate or is a multi-layer board having interleaved layers of plastic and metal conductors, with through-hole connections therebetween.

**11.** The method of claim 10 wherein the plastic substrate is glass-epoxy or paper-epoxy.

**12.** The method of claim 11 wherein the treated circuit board is contacted with an etchant solution selected from the group consisting of alkaline permanganate, sulfuric acid and chromic acid and then electroless plated.

**13.** The method of claim 12 wherein the plastic substrate before treatment is first contacted with an etchant.

**14.** The method of claim 13 wherein the etchant is sulfuric acid.

**15.** A method for treating an epoxy circuit board prior to plating comprising contacting the board at a temperature above 32°C with a composition and thereafter etching the board with an oxidizing solution, characterized in that the composition comprises:

(a) a compound represented by the general formula,

$$CH_3 - \underset{\displaystyle OR_1}{\underset{|}{CH}}(CH_2)_m\ CH_2 - O - R_2$$

wherein $R_1$ and $R_2$ are independently selected from the group consisting of hydrogen atoms, aryl groups and alkyl groups of 1-4 carbon atoms and m is 0 to 2; and

(b) a compound represented by the general formula,

$R_3\ (OCH_2CH_2)_n\ O - R_4$

wherein $R_3$ and $R_4$ are independently selected from the group consisting of arly groups and alkyl groups of 1-4 carbon atoms and n is 2 to 5; the composition comprising, by weight, about 10 g/l to saturation compound (a) and about 10 g/l to saturation compound (b), and the composition having a pH greater than 10; and

in that the oxidizing solution comprises alkaline permanganate.

**16.** The method of claim 15 wherein the temperature of treatment with compounds (a) and (b) is about 60° to 66°C and the contact time is less than about 10 minutes.

**17.** The method of claim 15 wherein the board is contacted with an etchant selected from the group consisting of sulfuric acid and chromic acid and mixtures thereof prior to treatment with compounds (a) and (b).

**18.** The method of claim 12 wherein the etchant solution is an alkaline permanganate solution.

**19.** The method of claim 15 wherein the etchant in step (b) is an alkaline permanganate solution.

**20.** The method of claim 19 wherein the treated circuit board is thereafter contacted with an alkaline permanganate etchant solution.

## Revendications

**1.** Composition alcaline destinée à améliorer l'adhérence de substrats plastiques à un revêtement métallique, composition caractérisée en ce qu'elle comprend :

(a) un composé représenté par la formule générale :

$$CH_3 - \underset{\displaystyle OR_1}{\overset{|}{CH}} (CH_2)_m CH_2 - O - R_2$$

dans laquelle
$R_1$ et $R_2$ sont choisis indépendamment dans le groupe comprenant des atomes d'hydrogène, des groupes aryl et des groupes alkyl d'atomes de carbone 1 - 4 et dans laquelle m est compris de 0 à 2; et
(b) un composé représenté par la formule générale :

$R_3 (OCH_2CH_2)_n O - R_4$

dans laquelle
$R_3$ et $R_4$ sont choisis indépendamment dans le groupe comprenant des groupes aryl et des groupes alkyl d'atomes de carbone 1 - 4 et dans laquelle n est compris de 2 à 5;
la composition comprenant en poids, environ 10 g/litre jusqu'à saturation de composé (a), et environ 10 g/litre jusqu'à saturation de composé (b), et la composition présentant un pH supérieur à 10.

2. Composition selon la revendication 1, caractérisée en ce que l'alcalinité est fournie par un hydroxyde de métal alcalin et représente environ 5 g/litre à 200 g/litre.

3. Composition selon la revendication 2, caractérisée en ce que le composé (a) comprend de l'éther de monométhyle de glycol propylène, et en ce que le composé (b) comprend du glycol diméthoxy tétraéthylène.

4. Composition selon la revendication 3, caractérisée en ce qu'elle contient environ 40 g/litre à 120 g/litre d'hydroxyde de métal alcalin, environ 40 g/litre à 120 g/litre de composé (a), et environ 40 g/litre de composé (b).

5. Composition selon la revendication 4, caractérisée en ce que l'hydroxyde de métal alcalin est de l'hydroxyde de sodium.

6. Procédé de traitement d'un substrat plastique avant revêtement, consistant à mettre la matière plastique en contact avec une composition à une température supérieure à 32° C, procédé caractérisé en ce que la composition comprend :
(a) un composé représenté par la formule générale :

$$CH_3 \underset{\displaystyle OR_1}{\overset{|}{CH}} (CH_2)_m CH_2 - O - R_2$$

dans laquelle
$R_1$ et $_R2$ sont choisis indépendamment dans le groupe comprenant des atomes d'hydrogène, des groupes aryl et des groupes alkyl d'atomes de carbone 1 - 4, et dans laquelle m est compris de 0 à 2; et
(b) un composé représenté par la formule générale :

$R_3 (OCH_2 CH_2)_n O - R_4$

dans laquelle
$R_3$ et $R_4$ sont choisis indépendamment dans le groupe comprenant des groupes aryl et des groupes alkyl d'atomes de carbone 1 - 4, et dans laquelle n va de 2 à 5;
la composition comprenant, en poids, environ 10 g/litre jusqu'à saturation de composé (a), et environ 10 g/litre jusqu'à saturation de composé (b), et la composition présentant un pH supérieur à 10.

**7.** Procédé selon la revendication 6, caractérisé en ce que le composé (a) comprend de l'éther de monométhyle glycol propylène, et en ce que le composé (b) comprend du glyxol diméthoxy tétra éthylène.

**8.** Procédé selon la revendication 6, caractérisé en ce que la température va d'environ 32° C jusqu'au minimum entre le point d'ébullition de la solution et le point de ramollissement de la matière plastique, et en ce que le temps est inférieur à environ 30 minutes.

**9.** Procédé selon la revendication 6, caractérisé en ce que la température est d'environ 60 à 66° C, et en ce que le temps de contact est inférieur à environ 10 minutes.

**10.** Procédé selon la revendication 9, caractérisé en ce que le substrat plastique fait partie d'une carte de circuit électronique comportant un conducteur métallique sur les faces supérieure et inférieure du substrat, ou constitue une carte multicouche munie de couches intercalées de matière plastique et de conducteurs métalliques, avec des perçages pour les connections des couches entre elles.

**11.** Procédé selon la revendication 10, caractérisé en ce que le substrat plastique est du verre époxy ou du papier époxy.

**12.** Procédé selon la revendication 11, caractérisé en ce que la carte de circuit traitée est mise en contact avec une solution de gravure à l'acide choisie dans le groupe comprenant un permanganate alcalin, de l'acide sulfurique et de l'acide chromique, puis ensuite revêtue sans électrodes.

**13.** Procédé selon la revendication 12, caractérisé en ce que le substrat plastique est tout d'abord mis en contact, avant traitement, avec un acide décapage.

**14.** Procédé selon la revendication 13, caractérisé en ce que l'acide de décapage est de l'acide sulfurique.

**15.** Procédé de traitement d'une carte de circuit époxy avant revêtement, consistant à mettre la carte en contact avec une composition à une température supérieure à 32° C, puis à attaquer ensuite la carte à l'acide par une solution oxydante, procédé caractérisé en ce que la composition comprend :
(a) un composé représenté par la formule générale :

$$\underset{\displaystyle OR_1}{CH_3 - \underset{|}{CH}} \; (CH_2)_m \; CH_2 - O - R_2$$

dans laquelle
$R_1$ et $R_2$ sont choisis indépendamment dans le groupe comprenant des atomes d'hydrogène, des groupes aryl et des groupes alkyl d'atomes de carbone 1 - 4, et dans laquelle m est compris de 0 à 2; et
(b) un composé représenté par la formule générale :

$R_3\ (OCH_2\ CH_2)_n\ O - R_4$

dans laquelle
$R_3$ et $R_4$ sont choisis indépendamment dans le groupe comprenant des groupes aryl et des groupes alkyl d'atomes de carbone 1 - 4, et dans laquelle n est compris de 2 à 5;
la composition comprenant, en poids, environ 10 g/litre jusqu'à saturation de composé (a), et environ 10 g/litre jusqu'à saturation de composé (b), et la composition présentant un pH supérieur à 10; et en ce que la solution oxydante est constituée par un permanganate alcalin.

**16.** Procédé selon la revendication 15, caractérisé en ce que la température de traitement avec les composés (a) et (b) est d'environ 60 à 66° C, et en ce que le temps de contact est inférieur à environ 10 minutes.

**17.** Procédé selon la revendication 15, caractérisé en ce qu'on met la carte en contact avec un acide de décapage choisi dans le groupe comprenant l'acide sulfurique, l'acide chromique et des mélanges de ces acides, avant le traitement par les composés (a) et (b).

**18.** Procédé selon la revendication 12, caractérisé en ce que la solution de décapage est une solution d'un permanganate alcalin.

**19.** Procédé selon la revendication 15, caractérisé en ce que le produit de décapage de l'étape (b) est une solution d'un permanganate alcalin.

**20.** Procédé selon la revendication 19, caractérisé en ce que la carte de circuit traitée est ensuite mise en contact avec une solution de gravure d'un permanganate alcalin.

**Patentansprüche**

**1.** Basische Zusammensetzung zum Verbessern der Haftung von Kunststoffsubstraten an Metallüberzügen, die folgendes aufweist:
(a) eine Verbindung gemäß der allgemeinen Formel

$$CH_3 - \underset{\displaystyle OR_1}{\underset{|}{C}}H(CH_2)_m\ CH_2 - O - R_2$$

wobei $R_I$ und $R_2$ jeweils unabhängig ausgewählt sind aus der Gruppe, die Wasserstoffatome, Arylgruppen und Alkylgruppen mit I-4 Kohlenstoffatomen umfaßt, und m = 0-2; und
(b) eine Verbindung gemäß der allgemeinen Formel

$R_3\ (OCH_2CH_2)_n\ O - R_4$

wobei $R_3$ und $R_4$ jeweils unabhängig ausgewählt sind aus der Gruppe, die Arylgruppen und Alkylgruppen mit I-4 Kohlenstoffatomen umfaßt, und n = 2-5;
wobei die Zusammensetzung gewichtsmäßig ca. I0 g/l bis zur Sättigung von Verbindung (a) und ca. I0 g/l bis zur Sättigung von Verbindung (b) aufweist und einen pH-Wert von mehr als I0 hat.

**2.** Zusammensetzung nach Anspruch I,
wobei die Basizität durch ein Alkalimetallhydroxid gegeben ist und ca. 5 g/l bis 200 g/l beträgt.

**3.** Zusammensetzung nach Anspruch 2,
wobei die Verbindung (a) Propylenglykolmonomethylether und die Verbindung (b) Dimethoxytetraethylenglykol aufweist.

**4.** Zusammensetzung nach Anspruch 3, die ca. 40 g/l bis I20 g/l Alkalimetallhydroxid, ca. 40 g/l bis I20 g/l der Verbindung (a) und ca. 40 g/l der Verbindung (b) enthält.

**5.** Zusammensetzung nach Anspruch 4, wobei das Alkalimetallhydroxid Natriumhydroxid ist.

**6.** Verfahren zum Behandeln eines Kunststoffsubstrats vor dem Metallisieren, wobei das Verfahren aufweist: In-Kontakt-Bringen des Kunststoffs bei einer Temperatur von mehr als 32 °C mit einer Zusammensetzung,
**dadurch gekennzeichnet,**
daß die Zusammensetzung aufweist:
(a) eine Verbindung gemäß der allgemeinen Formel

$$CH_3 - \underset{\displaystyle OR_1}{\underset{|}{C}}H(CH_2)_m\ CH_2 - O - R_2$$

wobei $R_1$ und $R_2$ jeweils unabhängig ausgewählt sind aus der Gruppe, die Wasserstoffatome, Arylgruppen und Alkylgruppen mit 1-4 Kohlenstoffatomen umfaßt, und m = 0-2; und
(b) eine Verbindung gemäß der allgemeinen Formel

$R_3\ (OCH_2CH_2)_n\ O - R_4$

wobei $R_3$ und $R_4$ jeweils unabhängig ausgewählt sind aus der Gruppe, die Arylgruppen und Alkylgruppen mit 1-4 Kohlenstoffatomen umfaßt, und n = 2-5;
wobei die Zusammensetzung gewichtsmäßig ca. 10 g/l bis zur Sättigung von Verbindung (a) und ca. 10 g/l bis zur Sättigung von Verbindung (b) aufweist und die Zusammensetzung einen pH-Wert von mehr als 10 hat.

7. Verfahren nach Anspruch 6, wobei die Verbindung (a) Propylenglykolmonomethylether und die Verbindung (b) Dimethoxytetraethylenglykol aufweist.

8. Verfahren nach Anspruch 6, wobei die Temperatur ca. 32 °C bis zum Siedepunkt der Lösung bzw. dem Erweichungspunkt des Kunststoffs, je nachdem, welcher davon niedriger ist, beträgt und die Zeit kürzer als ca. 30 min ist.

9. Verfahren nach Anspruch 6, wobei die Temperatur ca. 60-66 °C beträgt und die Kontaktzeit kürzer als ca. 10 min ist.

10. Verfahren nach Anspruch 9, wobei das Kunststoffsubstrat entweder Teil einer elektronischen Leiterplatte mit einer Metalleiterbahn auf der Ober- und der Unterseite des Substrats ist oder eine Mehrlagen-Leiterplatte mit zwischengefügten Schichten von Kunststoff und Metalleiterbahnen mit Durchgangsverbindungen ist.

11. Verfahren nach Anspruch 10, wobei das Kunststoffsubstrat Glasepoxid oder Papierepoxid ist.

12. Verfahren nach Anspruch 11, wobei die behandelte Leiterplatte mit einer Ätzlösung in Kontakt gebracht wird, die ausgewählt ist aus der Gruppe, die alkalisches Permanganat, Schwefelsäure und Chromsäure umfaßt, und dann durch chemische Metallabscheidung metallisiert wird.

13. Verfahren nach Anspruch 12, wobei das Kunststoffsubstrat vor der Behandlung zuerst mit einem Ätzmittel in Kontakt gebracht wird.

14. Verfahren nach Anspruch 13, wobei das Ätzmittel Schwefelsäure ist.

15. Verfahren zum Behandeln einer Epoxidharz-Leiterplatte vor der Metallisierung, wobei das Verfahren aufweist: In-Kontakt-Bringen der Leiterplatte bei einer Temperatur oberhalb 32 °C mit einer Zusammensetzung und anschließendes Ätzen der Leiterplatte mit einer oxidierenden Lösung,
**dadurch gekennzeichnet,**
daß die Zusammensetzung aufweist:
(a) eine Verbindung gemäß der allgemeinen Formel

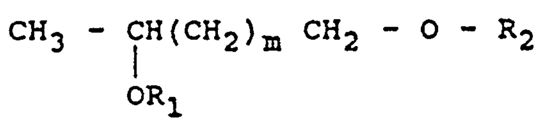

wobei $R_1$ und $R_2$ jeweils unabhängig ausgewählt sind aus der Gruppe, die Wasserstoffatome, Arylgruppen und Alkylgruppen mit 1-4 Kohlenstoffatomen umfaßt, und m = 0-2; und
(b) eine Verbindung gemäß der allgemeinen Formel

$R_3\ (OCH_2CH_2)_n\ O - R_4$

wobei $R_3$ und $R_4$ jeweils unabhängig ausgewählt sind aus der Gruppe, die Arylgruppen und

Alkylgruppen mit I-4 Kohlenstoffatomen umfaßt, und n = 2-5;
wobei die Zusammensetzung gewichtsmäßig ca. I0 g/l bis zur Sättigung von Verbindung (a) und ca. I0 g/l bis zur Sättigung von Verbindung (b) aufweist und die Zusammensetzung einen pH-Wert von mehr als I0 hat; und
daß die oxidierende Lösung alkalisches Permanganat aufweist.

**16.** Verfahren nach Anspruch I5, wobei die Behandlungstemperatur mit den Verbindungen (a) und (b) ca. 60-66 °C beträgt und die Kontaktzeit kürzer als ca. I0 min ist.

**17.** Verfahren nach Anspruch I5, wobei die Leiterplatte vor der Behandlung mit den Verbindungen (a) und (b) mit einem Ätzmittel in Kontakt gebracht wird, das ausgewählt ist aus der Gruppe, die Schwefel- und Chromsäure sowie Gemische davon umfaßt.

**18.** Verfahren nach Anspruch I2, wobei die Ätzlösung eine alkalische Permanganatlösung ist.

**19.** Verfahren nach Anspruch I5, wobei das Ätzmittel in Schritt (b) eine alkalische Permanganatlösung ist.

**20.** Verfahren nach Anspruch I9, wobei die behandelte Leiterplatte anschließend mit einer alkalischen Permanganat-Ätzlösung in Kontakt gebracht wird.